**Europäisches Patentamt**

**European Patent Office**

**Office européen des brevets**

(19)

(11) Veröffentlichungsnummer : **0 039 019**
**B1**

(12) # EUROPÄISCHE PATENTSCHRIFT

(45) Veröffentlichungstag der Patentschrift :
**09.01.85**

(51) Int. Cl.⁴ : **G 01 N 27/72, G 01 R 33/14, G 01 N 33/20**

(21) Anmeldenummer : **81102963.6**

(22) Anmeldetag : **16.04.81**

(54) **Vorrichtung zur kontinuierlichen, berührungslosen Überwachung des Gefügezustandes von Kaltband.**

(30) Priorität : **24.04.80 DE 3015894**

(43) Veröffentlichungstag der Anmeldung :
**04.11.81 Patentblatt 81/44**

(45) Bekanntmachung des Hinweises auf die Patenterteilung : **09.01.85 Patentblatt 85/02**

(84) Benannte Vertragsstaaten :
**BE DE GB SE**

(56) Entgegenhaltungen :
**AT-B-   176 906**
**DE-B- 1 046 769**
**DE-B- 2 050 827**
**DE-B- 2 065 826**
**US-A- 2 810 882**

(73) Patentinhaber : **Siemens Aktiengesellschaft**
**Berlin und München Wittelsbacherplatz 2**
**D-8000 München 2 (DE)**

(72) Erfinder : **Gfrerer, Manfred, Dr.**
**Anderlohrstrasse 27**
**D-8520 Erlangen (DE)**

## Beschreibung

Die Erfindung betrifft eine Vorrichtung zur kontinuierlichen berührungslosen Überwachung des Gefügezustandes eines durch eine Glühbehandlungsanlage geführten Kaltbandes aus magnetisierbarem Material mit einer ersten Meßanordnung, welche folgende Komponenten enthält :

(i) einen Elektromagneten zur lokalen Magnetisierung des Kaltbandes, welcher eine auf einem Eisenkern angeordnete und an eine Wechselstromquelle angeschlossene Erregerspule trägt und

(ii) einen eine Meßspule oder eine Hallsonde aufweisenden Detektor zur Erfassung der vom Elektromagneten im Kaltband erzeugten Magnetisierung.

Eine kontinuierliche, berührungslose Überwachung des Gefügezustandes eines langgestreckten, magnetisierbaren Materials vorzugsweise nach einer Wärmebehandlung ist aus DE-B-20 50 827 und DE-B-20 65 826 bekannt. Für die Beurteilung des Gefügezustandes wird hier als Meßgröße die scheinbare Remanenz verwendet, die ein Maß für die Koerzitivfeldstärke darstellt. Die Koerzitivfeldstärke erreicht ein Minimum, wenn das Band durch eine Glühbehandlung vollständig rekristallisiert ist. Die Meßanordnung umfaßt hier eine Magnetisierungsvorrichtung aus zylinderförmigen Dauermagneten und einem eine Hallsonde enthaltenden Meßfühler. Das Band durchläuft die durch den Abstand zwischen der Magnetisierungsvorrichtung und dem Meßfühler gegebene Meßstrecke, und die vom Meßfühler erzeugte Hallspannung wird als Maß für die scheinbare Remanenz gewertet und aufgezeichnet. Nachteilig bei diesem Verfahren ist jedoch, daß die Meßanordnung auf Änderungen des Abstandes zwischen dem Band und der Meßvorrichtung und dem Meßfühler sowie auf Erschütterungen empfindlich reagiert und durch remanente Fremdfelder beeinflußt wird.

Ausgehend von diesem Stand der Technik liegt der Erfindung die Aufgabe zugrunde, eine Einrichtung zu schaffen, die eine berührungslose Überwachung des Gefügezustandes von magnetisierbarem Bandmaterial unabhängig von Lageänderungen des Bandes relativ zur Meßeinrichtung ermöglicht und die aufgrund der gemessenen Abweichungen den Glühprozeß auf einen gewünschten Sollwert steuert.

Diese Aufgabe wird durch die in Anspruch 1 angegebene Erfindung gelöst. Der dadurch erreichte Vorteil ist vor allem darin zu sehen, daß sich durch die Möglichkeit, das Band über die Erregerspule im Bereich der maximalen Induktion zu magnetisieren, eine hohe Meßempfindlichkeit der Meßvorrichtung erzielen läßt. Aufgrund der Anordnung der Erregerspule und des Meßfühlers auf einem gemeinsamen Eisenkern werden darüberhinaus Informationsverluste wirksam vermieden. Gegebenenfalls bestehende magnetische Restfelder, die die Messung verfälschen könnten, werden durch die Anwendung eines magnetischen Wechselfeldes eliminiert.

Anhand der Zeichnungen wird die Erfindung im folgenden näher erläutert.

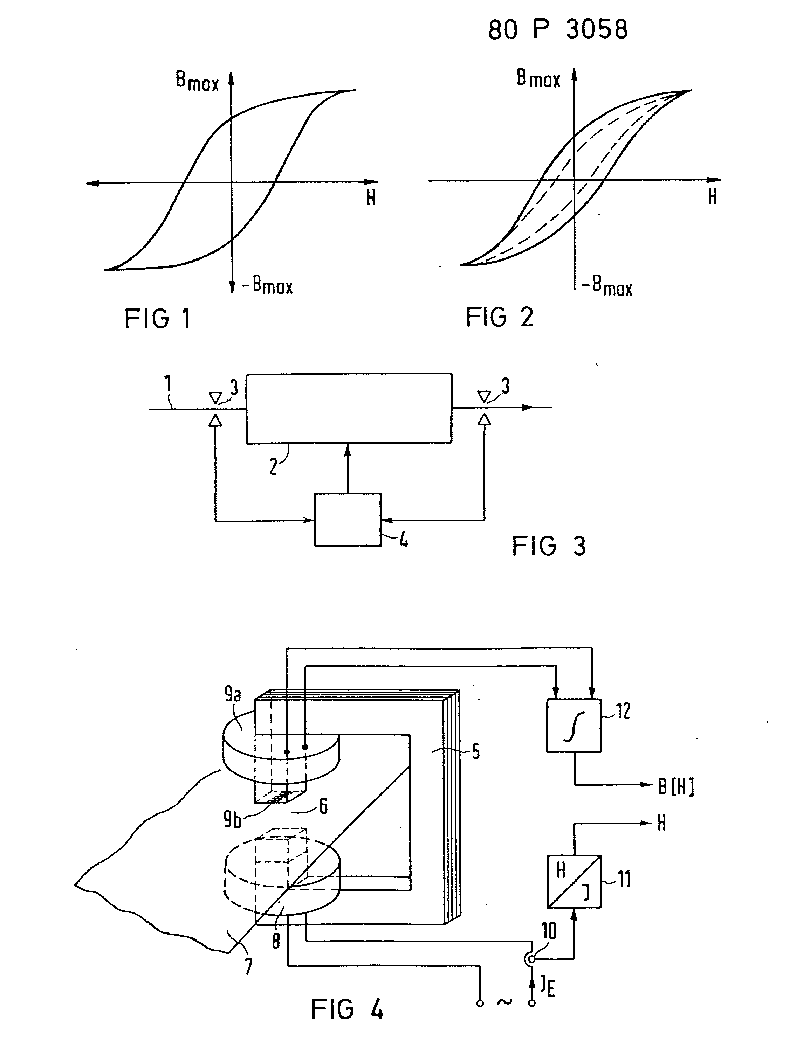

Wie Figur 1 und 2 zeigen, ist die Hysteresefläche eines kaltverformten, ferromagnetische Anteile enthaltenden Materials (Figur 1) größer als die Hysteresefläche eines zur Rekristallisation geglühten Materials (Figur 2). Durch Messung der magnetischen Hysterese sind daher Rückschlüsse auf den Gefügezustand von magnetisierbarem Bandmaterial möglich.

Entsprechend der schematischen Darstellung in Figur 3 durchläuft ein Band 1 aus magnetisierbarem Material kontinuierlich eine Glühbehandlungsanlage 2. Auf der Einlaufseite und auf der Auslaufseite der Glühbehandlungsanlage ist je eine Meßanordnung 3 angeordnet, deren Meßwerte einem Rechner 4 zugeführt werden. Der Rechner vergleicht die Meßwerte miteinander und steuert in Abhängigkeit von der aus dem Vergleich resultierenden Differenz die Glühtemperatur und/oder die Verweildauer des Bandes in der Glühzone derart, daß das gewünschte Gefüge im Band erreicht wird.

In Figur 4 ist die Meßanordnung in perspektivischer Darstellung wiedergegeben. Ein nach Art eines Transformatorkernes ausgeführter Eisenkern 5 ist mit einem Luftspalt 6 versehen, der von einem Band 7 durchlaufen wird. Der eine an den Luftspalt angrenzende Endabschnitt des Eisenkernes trägt eine an eine Wechselstromquelle anzuschließende Erregerspule 8, die vorzugsweise derart bemessen ist, daß sie die maximale Induktion liefert. Auf dem anderen Endabschnitt des Eisenkernes ist eine Spule 9a als Meßfühler angeordnet. Anstelle einer Spule kann auf der Stirnfläche dieses Endabschnittes beispielsweise eine Hallsonde oder Feldplatte 9b angebracht sein. Die Sekundärseite eines Stromwandlers 10, der den durch die Erregerspule 8 fließenden Strom erfaßt, ist mit einer Einrichtung 11 verbunden, die den dem Erregerstrom proportionalen Wert in eine der magnetischen Feldstärke H proportionale Größe umformt. Die in der Spule 9a oder der Hallsonde bzw. Feldplatte 9b induzierte Spannung wird über einen Umformer 12, beispielsweise einen Integrator, in eine der magnetischen Induktion B proportionale Meßgröße umgesetzt. Aus den Größen B und H ermittelt der Rechner 4 die Hysteresefläche. Die Differenz der Hystereseflächen auf der Einlauf- und der Auslaufseite der Glühbehandlungsanlage stellt ein Maß für die Güte der Rekristallisierung dar.

## Ansprüche

1. Vorrichtung zur kontinuierlichen, berührungslosen Überwachung des Gefügezustandes eines durch eine Glühbehandlungsanlage geführten Kaltbandes aus magnetisierbarem Material mit

a) einer ersten Meßanordnung, welche folgende Einrichtungen enthält :

(i) einen Elektromagneten zur lokalen Magnetisierung des Kaltbandes (1), welcher eine auf einem Eisenkern (5) angeordnete und an eine Wechselstromquelle angeschlossene Erregerspule (8) trägt,

(ii) einen eine Meßspule (9a) oder eine Hallsonde (9b) aufweisenden Detektor (9a, 9b, 12) zur Erfassung der vom Elektromagneten im Kaltband erzeugten Magnetisierung, dadurch gekennzeichnet, daß

b) die erste Meßanordnung weiterhin einen Geber (10, 11) für die Magnetisierungsfeldstärke des Elektromagneten besitzt und die Meßspule (9a) oder die Hallsonde (9b) auf dem Eisenkern (5) angeordnet ist, der außerdem mit einem Luftspalt (6) zum Durchtritt des Kaltbandes (1) versehen ist,

c) eine zweite Meßanordnung vorgesehen ist, die gleichartig wie die erste Meßanordnung aufgebaut ist,

d) die eine der beiden Meßanordnungen vor und die andere hinter der Glühbehandlungsanlage (2) angeordnet ist,

e) ein Rechner (4) vorgesehen ist, der aus den Ausgangssignalen des Detektors und des Gebers einer jeden Meßanordnung jeweils die von der Hysteresekurve des Kaltbandes am Ort der betreffenden Meßanordnung umschlossene Fläche sowie den Unterschied zwischen den beiden so erhaltenen Flächen ermittelt und die Glühtemperatur und/oder die Dauer der Glühbehandlung in Abhängigkeit von diesem Unterschied im Sinne einer Konstanthaltung des Gefügezustandes regelt.

2. Vorrichtung nach Anspruch 1, dadurch gekennzeichnet, daß die Erregerspule (8) und die Meßspule (9a) oder Hallsonde (9b) auf den den Luftspalt (6) begrenzenden Abschnitten des Eisenkerns (5) angeordnet sind.

## Claims

1. Apparatus for the continuous, contactless control of the structural state of a cold-drawn strip of magnetisable material which is passed through an annealing system, having

a) a first measuring arrangement which comprises the following devices :

(i) an electromagnet for the local magnetization of the cold-drawn strip (1) which carries an exciting coil (8) which is arranged on an iron core (5) and is connected to an a. c. source,

(ii) a detector (9a, 9b, 12) which has a measuring coil (9a) or a Hall probe (9b) and which serves to detect the magnetization produced by the electromagnet in the cold-drawn strip, characterised in that

b) the first measuring arrangement also has generator (10, 11) for the magnetization field strength of the electromagnet, and the measuring coil (9a), or the Hall probe (9b), is arranged on the iron core (5), which is furthermore provided with an air gap (6) for passing the cold-drawn strip (1) through,

c) there is provided a second measuring arrangement which is similarly constructed to the first measuring arrangement,

d) one of the two measuring arrangements is arranged in front of and the other behind the annealing system (2),

e) there is provided a computer (4) which from the output signals of the detector and the generator of each measuring arrangement, respectively determines both the area which is enclosed by the hysteresis curve of the cold-drawn strip at the location of the respective measuring arrangement, and the difference between the two areas obtained in this manner and controls the annealing temperature and/or the duration of the annealing in dependence upon this difference so as to keep the structural state constant.

2. Apparatus as claimed in Claim 1, characterised in that the exciting coil (8) and the measuring coil (9a), or Hall probe (9b), are arranged on the sections of the iron core (5) which delimit the air gap (6).

## Revendications

1. Dispositif de contrôle continu et sans contact de l'état de la structure d'un feuillard laminé à froid, en une matière magnétique et passant par une installation de recuit, comprenant

a) un premier montage de mesure, qui contient les dispositifs suivants :

(i) un électroaimant pour aimanter localement le feuillard laminé à froid (1), et portant une bobine d'excitation (8) montée sur un noyau de fer et raccordée à une source de courant alternatif,

(ii) un détecteur (9a, 9b, 12) pour saisir l'aimantation produite dans le feuillard laminé à froid par l'électroaimant et présentant une bobine de mesure (9a) ou une sonde de Hall (9b), caractérisé en ce que,

b) le premier montage possède en outre un générateur (10, 11) pour l'intensité du champ d'aimantation de l'électroaimant et la bobine de mesure (9a) ou la sonde de Hall (9b) est montée sur le noyau de fer (5), qui est muni en outre d'un entrefer (6) pour le passage du feuillard laminé à froid (1),

c) il est prévu un second montage de mesure, constitué de la même façon que le premier,

d) l'un des deux montages de mesure est en amont et l'autre en aval de l'installation de recuit,

e) il est prévu une calculatrice (4) qui, à partir des signaux de sortie du détecteur et du générateur de chaque montage de mesure, détermine respectivement la surface entourée par la courbe d'hystérèse du feuillard laminé à froid à l'emplacement du montage de mesure concerné, ainsi que la différence entre les deux surfaces ainsi obtenues et règle la température et/ou la durée du recuit en fonction de cette différence en vue de maintenir constant l'état de la structure.

2. Dispositif suivant la revendication 1, caractérisé en ce que la bobine d'excitation (8) et la bobine de mesure (9a) ou la sonde de Hall (9b) sont montées sur les sections du noyau de fer (5) qui délimitent l'entrefer (6).

80 P 3058

FIG 1

FIG 2

FIG 3

FIG 4

B[H]

H